# EUROPEAN PATENT SPECIFICATION

(11) **EP 1 894 024 B1**
(45) Date of publication and mention of the grant of the patent: **23.11.2016**
(21) Application number: 06763660.5
(22) Date of filing: 13.06.2006
(51) Int. Cl.: G01R 15/16, G01R 15/26

(54) **DEVICE TO DETECT WITHOUT CONTACT THE TENSION IN AN ELECTRIC CABLE**
EINRICHTUNG ZUM KONTAKLOSEN DETEKTIEREN DER SPANNUNG IN EINEM ELEKTRISCHEN KABEL
DISPOSITIF POUR DETECTER, SANS CONTACT, LA TENSION DANS UN CABLE ELECTRIQUE

(30) Priority: 14.06.2005 IT UD20050099
(43) Date of publication of application: 05.03.2008
(73) Proprietor: Littelfuse Commercial Vehicle Products, Italy S.R.L., 37045 Legnago (IT)
(72) Inventor: SPAGNUL, Stefano, I-33051 Aquileia (IT); DE MONTE, Stefano, I-33010 Colugna (IT)
(74) Representative: Petraz, Gilberto Luigi
(86) International application number: PCT/EP2006/063131
(87) International publication number: WO 2006/134097

(56) References cited:
- DE-A1- 10 021 714
- US-A- 4 928 057

## Description

### FIELD OF THE INVENTION

The present invention concerns a device to detect the tension in an electric cable without any direct contact with the conductor element of the cable to which the tension to be detected is applied. The invention is advantageously but not exclusively applied in the field of motor vehicles, or in general in the so-called automotive field, for example to intercept the signals to switch on the luminous indicators of a motor vehicle and to send them to the corresponding indicators of a trailer.

### BACKGROUND OF THE INVENTION

The use of trailers is widespread, such as for example caravans, trailers or transport trolleys, to be attached to a motor vehicle or to a tractor truck, by means of a suitable hook. Trailers normally have luminous indicators which have substantially the same functions as those present on the motor vehicle, and indicate when the motor vehicle changes direction, brakes, goes into reverse, etc.

The correct functioning and perfect synchrony of the indicators on trailers with respect to those on the towing vehicle are essential for road safety since they are the only ones visible to the people traveling behind or adjacent to vehicles with a trailer.

Luminous indicators of the motor vehicle are fed by means of electric cables with respective signals at a direct tension comprised between 6 V and 48 V; the signals are intercepted so as to be then transmitted to the luminous indicators of the trailer by means of respective cables.

In order to do this, known solutions provide clamps or hooks that are applied on the conductor until the insulating sheath is cut and the metal conductor of the cable itself is reached. This contact with the conductor allows to pick up the switch-on signal and to transmit it to the central unit which commands the luminous indicators of the trailer.

These solutions have the disadvantage that they intervene directly on the electric plant of the motor vehicle, and in a potentially damaging manner on the integrity of the conductors.

Some producers of motor vehicles therefore do not allow to use such known solutions, the penalty for which is the loss of the guarantee on the functioning of the electric plant of the motor vehicle.

Devices are also known to detect without contact the electric tension present on metal surfaces, for example the printing rollers on which toner is deposited; such devices however are extremely expensive and bulky, and extremely sensitive to electromagnetic interferences, which are typical of motor vehicle environments.

Document US-A-6.104.181 describes a voltmeter suitable to detect without contact the tension in a high tension line, which uses a capacitive divider which makes use of an acoustic wave generated by an antenna and a piezoelectric element which, when stressed, determines a variation in the time of flight of the acoustic wave. The detection of the variation in the time of flight of the acoustic wave allows to detect, indirectly, the value of the electric tension of the high tension line.

Document DE-A1-10021714 discloses a method that employs the application of at least one measurement electrode to an insulated sheath that surrounds an electrode. The measurement electrode is applied on the sheath in shape-and force-locking manner under a high definite pressure, forming a measurement capacitor, without any gap between the electrode and the sheath. The insulating sheath is set into mechanical vibration by a piezoelectric device at a certain auxiliary frequency so as to vary a measurement capacitance. The measurement signal, which depends on the varying measurement capacitance and conductor potential, is finally detected and evaluated.

In this disclosure, in order to obtain an information about the tension present in the electric cable, the piezoelectric device and the measurement electrode are electrically connected each other, in order to allow the application to the electrode of an auxiliary tension supplied by a tension source.

A purpose of the present invention is to achieve a device that allows to detect without contact the tension present in an electric cable, in particular suitable for use in the field of automobiles, and which does not therefore have the disadvantages and potential harmfulness of known devices.

The Applicant has devised, tested and embodied the present invention to overcome the shortcomings of the state of the art and to obtain these and other purposes and advantages.

### SUMMARY OF THE INVENTION

The present invention is set forth and characterized in the main claim, while the dependent claims describe other characteristics of the invention or variants to the main inventive idea.

In accordance with the above purpose, a detection device according to the present invention is employed, for example, in a motor vehicle, advantageously suitable for towing at least a trailer, in order to detect without contact the tension present in an electric cable of the type consisting of at least a conductor wrapped in an insulating sheath.

According to a characteristic of the present invention, the detection device comprises at least an electrically conducting element, or armor, or measurement electrode, associated with means able to induce a vibration thereon, in order to induce thereon a variation of charge correlated to the tension present in the electric cable.

The armor, or measurement electrode, is disposed in substantial proximity with, but in any case at a certain minimum distance from, the insulating sheath of the electric cable so as to couple capacitively with the conductor, which thus functions as a first armor, and to achieve therewith a capacitor, whose dielectric is defined at least by the insulating sheath and by the air interspace that separates the armor from the insulating sheath.

According to the invention, the air interspace is equal to at least 2 tenths of a millimeter, even though in practice it is preferable, for reasons of operating safety, to have an interspace equal to about 2 millimeters.

The quantity of charge present on the armor is directly proportional, with respect to the capacity of the capacitor, to the value of the tension on the conductor, and the capacity in turn depends on the geometric characteristics of the capacitor.

When the armor is made to vibrate, the capacity of the capacitor also varies as a consequence, and therefore the charge on the armor also varies over time. This temporal variation defines a current, here also called detected current, having at least the intensity correlated to the intensity of the tension on the conductor. To be more exact, the intensity of said detected current varies in a substantially linear manner with the intensity of the tension on the conductor.

By picking up the detected current, the detection device according to the invention allows to determine without contact the presence of tension on the conductor and possibly to detect the value thereof, without encountering the shortcomings of the state of the art.

More particularly, the presence of an air interspace between the armor which functions as a measurement electrode and the insulating sheath of the conductor cable allows to avoid problems of stress and deformation on the sheath which, being elastic, would be subjected to repeated cycles of compression and expansion if put in contact with the vibrating armor. By leaving an air interspace we prevent the measurement from being falsified by modifications in the geometric constants, both the average distance between the conductor cable and the measurement electrode, and the variations in the amplitude of oscillation.

According to one form of embodiment, the means able to induce a vibration in the armor comprise at least a piezoelectric element mechanically connected to the armor. The piezoelectric element is made to oscillate by means of a periodic electric signal, for example a sinusoidal, square or triangular wave, or other.

In a first embodiment, the piezoelectric element is directly attached to the armor. According to other constructional embodiments, between the piezoelectric element and the armor it is provided to use a so-called mechanical amplifier, the function of which is to amplify the entity of the oscillation imparted to the armor given the same deformation generated by the excitation of the piezoelectric element.

The embodiment that provides the mechanical amplifier allows to reduce the frequencies of oscillation used, and hence to use simpler and hence cheaper electronic designs.

Moreover, by moving the position of the piezoelectric element with respect to the conductor cable and to the measurement electrode, thanks to the use of said mechanical amplifier, it is possible to avoid unwanted induction phenomena.

According to a variant, in order to make the armor vibrate it is provided to use magnetostrictive materials or electromechanical systems.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a lateral view, partly sectioned and schematized, of a device according to the present invention;
- fig. 2 is a section of a detail of the device from II to II in fig. 1;
- fig. 3 shows an electronic circuit of the device in fig. 1;
- figs. 4 and 5 show two alternative forms of embodiment of a device according to the present invention.

### DETAILED DESCRIPTION OF SOME PREFERENTIAL FORMS OF EMBODIMENT

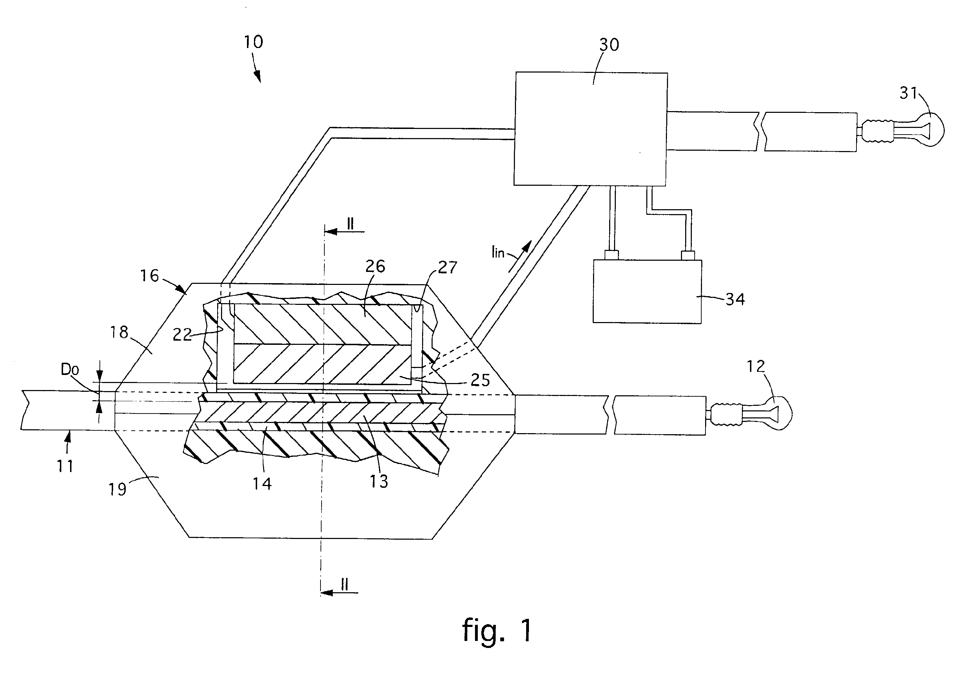

With reference to fig. 1, a device 10 according to the present invention is employed, for example in a motor vehicle, to detect without contact the tension in an electric cable 11 connected to a luminous indicator 12 of the motor vehicle and to send it to a trailer of said motor vehicle.

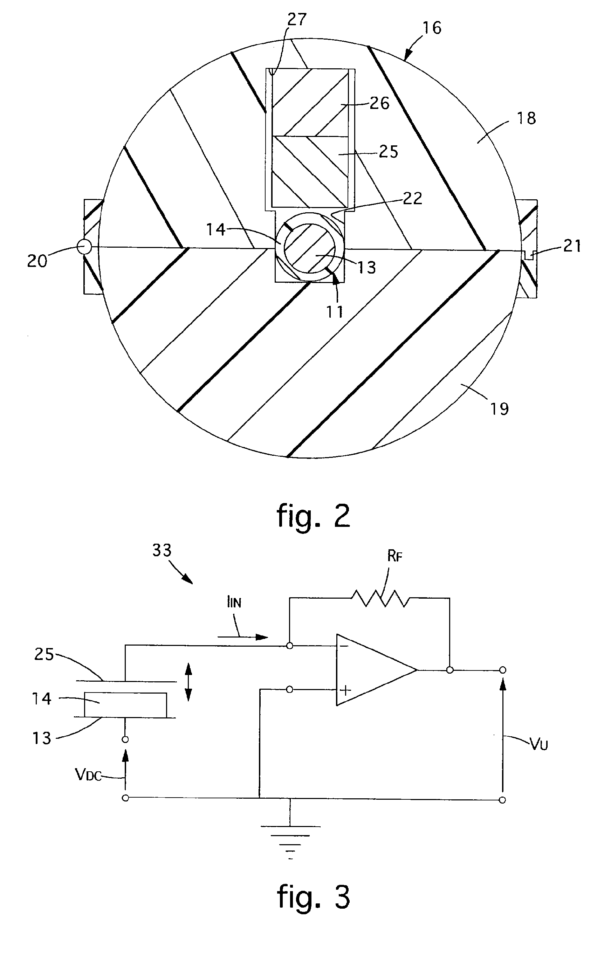

The electric cable 11 (figs. 1 and 2) comprises a metal conductor 13 having a diameter of about 1.7 mm and wrapped in an insulating sheath 14 of a plastic type, having a diameter of about 2.2 mm.

The device 10 comprises a support 16 made for example of plastic material, having a tubular shape and consisting of two elements, respectively first 18 and second 19, connected to each other by means of a hinge 20 and able to be reciprocally clamped by means of a snap-in element 21.

The two elements 18 and 19 define inside a shaped compartment 22, inside which the electric cable 11 is inserted under pressure and thus clamped to the support 16. Moreover, the closure achieved by means of the snap-in element 21 guarantees a good seal which prevents the entrance of liquids or humidity into the compartment 22.

The device 10 also comprises an armor 25, made of metal or other electrically conducting material and, in the case shown here as an example, a piezoelectric element 26, fixed to a wall 27 of the compartment 22 and to which in turn said armor 25 is fixed.

The armor 25, which functions substantially as a measurement electrode, and the piezoelectric element 26, in the embodiment shown in figs. 1 and 2, have a substantially square cross section with a side of about 3 mm and a length of about 15 mm.

The armor 25 is disposed in close proximity with the insulating sheath 14 and is distanced from it by a few tenths of a millimeter, at least two tenths of a millimeter, for the reasons explained hereafter, and from the metal conductor 13 by an average distance D₀ of about 2 mm. In this way, the armor 25 achieves, together with the metal conductor 13, a coupling of a capacitive type, therefore defining a capacitor, the dielectric of which is represented by the insulating sheath 14 and the air.

The armor 25 is also mechanically connected to the piezoelectric element 26 so that, when the latter is made to vibrate, the armor 25 vibrates too, varying the distance from the metal conductor 13 and consequently varying the capacity of said capacitor which, as is known, is defined by the geometric characteristics of the capacitor.

Since the amplitude of the vibration can be estimated at a value of about a tenth of a millimeter, the presence of an air interspace of a minimum of two tenths of a millimeter between the armor 25 and the insulating sheath 14 guarantees that, during functioning, there is never any contact between these two elements.

In practice, an air interspace of about 2 millimeters gives the certainty that, during functioning, there is no mechanical interference between the armor 25 and the sheath 14, thus avoiding, as already mentioned before, problems concerning the variation in the geometric constants, and hence the result of the measurement, as external conditions vary, particularly temperature, in which the measurement is carried out.

Given the same tension V_{DC} present on the metal conductor 13, and varying the capacity of said capacitor, the charge induced on the armor 25 is consequently varied. This temporal variation in the charge produces a signal of detected current I_{IN} which is correlated to the tension V_{DC} present in the metal conductor 13.

The device 10 also comprises a command and control unit 30, shown schematically in fig. 1, which carries out a conditioning and amplification of the signal of detected current I_{IN}, processes it and consequently feeds a second luminous indicator 31 disposed in the trailer.

To give an example, the conditioning and amplification are achieved by means of an electronic circuit 33, whose electric diagram is shown in fig. 3, comprising an operational amplifier, for example LM308AN, in a configuration as a trans-impedance amplifier, that is to say, able to effect the conversion of the detected current I_{IN} into an output tension V_{U} proportional thereto.

The detected current I_{IN} is sent to the inverting clamp of the operational amplifier, and between this and the outlet clamp a resistance R_{F} is connected, of a value, for example, equal to about 1 MΩ. As is known, this configuration is inverting and has a gain equal to the value of R_{F}. The value of the output tension is therefore V_{U} = -I_{IN}·R_{F}. In this way, it is possible to acquire signals of current I_{IN} in the order of nano-amperes, with working frequencies, for example, in the order of about 1 KHz.

The command and control unit 30 then processes the output tension V_{U} to command the electric feed to the luminous indicator 31 of the trailer by means of a battery 34.

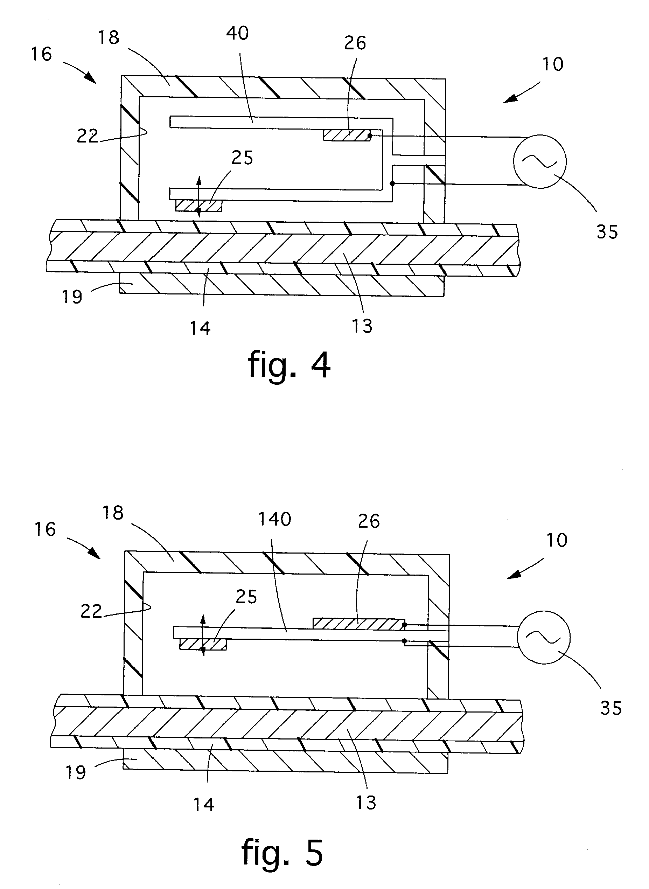

The command and control unit 30 also comprises an electric generator 35 (figs. 4 and 5) able to feed the piezoelectric element 26 with a, for example, sinusoidal tension, having an amplitude comprised between about 1 V and 100 V and a frequency comprised between about 10 Hz and about 1000 Hz, to make it vibrate at a desired frequency.

The piezoelectric element 26 is maintained in constant vibration, so that the armor 25 is able to provide promptly the signal of detected current I_{IN} to the electronic circuit 33.

The signal of current I_{IN} generated by the armor 25 is correlated to the feed tension V_{DC} on the metal conductor 13. To be more exact, as the amplitude of the feed tension V_{DC} increases, the amplitude of the signal current I_{IN} increases linearly.

According to the variants shown in figs. 4 and 5, between the piezoelectric element 26 and the armor 25 a mechanical amplifier is disposed, in the form of a winged metal element 40 in fig. 4 and a metal foil element 140 in fig. 5.

The function of the mechanical amplifier 40, 140 is to amplify the entity of the oscillation generated by excitation of the piezoelectric element 26, so that the armor 25 is subject to an oscillation of greater entity even when there is a much reduced oscillation of the piezoelectric element 26.

Thanks to this solution, on the one hand it is possible to use lower oscillation frequencies and hence less expensive electronic devices, on the other hand the piezoelectric element 26 is distanced from the conductor cable 13 and from the armor 25, preventing induction phenomena.

The device 10 according to the invention needs a preliminary calibration of the command and control unit 30, which is effected at the moment of installation, and which pre-supposes that only two conditions are identified, corresponding to the absence of tension V_{DC} on the conductor 13, and the presence thereof.

Generally, the electric feed plant of the luminous indicators of motor vehicles provides a direct feed tension V_{DC} with two values: 0 V, corresponding to the absence of a signal, and a tension comprised between 6 V and 48 V, normally 12 V for motor vehicles, corresponding to the feed tension of said indicators.

Thanks to the linearity of the link between the tension V_{DC} on the conductor 13 and the detected current I_{IN}, the invention allows to detect without contact any tension whatsoever, both direct and alternating, that varies inside the calibration range.

It is clear that modifications and/or additions of parts may be made to the device 10 as described heretofore, without departing from the scope of the present invention.

In an advantageous solution, parallel to the resistance R_{F} of the operational amplifier, a capacitor is electrically connected which reduces the high-frequency noise and the risk of oscillations of the electronic circuit 33.

It is also clear that, although the present invention has been described with reference to some specific examples, a person of skill in the art shall certainly be able to achieve many other equivalent forms of device to detect without contact the tension in an electric cable, having the characteristics as set forth in the claims and hence all coming within the field of protection defined thereby.

## Claims

1. Device to detect without contact the tension (V_{DC}) in an electric cable (11), particularly in the automotive field, said electric cable (11) comprising at least a conductor (13) wrapped in an insulating sheath (14), wherein the device comprises at least a measurement electrode (25) disposed in proximity with said conductor (13) and associated with means (26) able to induce a vibration in order to produce thereon a variation in charge correlated to the tension (V_{DC}) present in said electric cable (11), wherein said measurement electrode (25) is disposed at a certain distance with respect to said insulating sheath (14) and forms with said conductor (13) a capacitor having as electrodes the measurement electrode (25) and the conductor (13) itself, and as dielectric both said insulating sheath (14) and the air interspace which separates said measurement electrode (25) from the insulating sheath (14), wherein said air interspace is equal to at least two tenths of a millimeter to guarantee that, during functioning and vibration of the measurement electrode (25), there is never any contact between said sheath (14) and said measurement electrode (25), the device also comprising at least a supporting element (16) having a shaped inner compartment (22), in which at least said measurement electrode (25) and said means (26) able to induce a vibration are disposed, said supporting element (16) further comprising at least a longitudinal channel in which said electric cable (11) is inserted and fixed.

2. Device as in claim 1, **characterized in that** said measurement electrode (25) develops at least partly around said electric cable (11).

3. Device as in claim 1, **characterized in that** said variation in charge defines over time a detected current (I_{IN}) which is substantially proportional to said tension (V_{DC}) in said electric cable (11).

4. Device as in claim 1, **characterized in that** said means able to induce a vibration comprise at least a piezoelectric element (26).

5. Device as in claim 4, **characterized in that** said piezoelectric element (26) is fed by means of an alternating current.

6. Device as in claim 4, **characterized in that** between said piezoelectric element (26) and said measurement electrode (25) there is at least an oscillation amplifier element (40, 140).

7. Device as in claim 6, **characterized in that** said oscillation amplifier element is in the form of a winged metal element (40).

8. Device as in claim 6, **characterized in that** said oscillation amplifier element is in the form of a metal foil element (140).

9. Device as in claim 1, **characterized in that** said supporting element (16) comprises two shells (18, 19) joined together by a hinge element (20) and clamped on the side opposite the hinge (20) by a snap-in element (21).

10. Device as in claim 3, **characterized in that** it also comprises a command and control unit (30) able to condition and amplify said detected current (I_{IN}), and to process it in order to feed signaling means (31).

## Patentansprüche

1. Vorrichtung zur berührungslosen Erkennung der Spannung (V_{DC}) in einem elektrischen Kabel (11), insbesondere im Automobilbereich, wobei das elektrische Kabel (11) mindestens einen Leiter (13) umfasst, der von einem isolierendem Mantel (14) umhüllt ist, wobei die Vorrichtung zumindest eine Messelektrode (25) umfasst, die in der Nähe des Leiters (13) angeordnet ist und zu Mitteln (26) gehört, die eine Schwingung anregen können, um daraufhin eine mit der in dem elektrischen Kabel (11) vorliegenden Spannung (V_{DC}) in Zusammenhang stehende Änderung der Ladung zu erzeugen, wobei die Messelektrode (25) mit einem gewissen Abstand zu dem isolierenden Mantel (14) angeordnet ist und mit dem Leiter (13) einen Kondensator bildet, dessen Elektroden die Messelektrode (25) und der Leiter (13) selbst darstellen und dessen Dielektrikum sowohl der isolierende Mantel (14) als auch der Luftspalt, der die Messelektrode (25) von dem isolierendem Mantel (14) trennt, darstellen, wobei der Luftspalt zumindest zwei Zehntel eines Millimeters beträgt, damit sichergestellt Wird, dass bei Betrieb und Schwingung der Messelektrode (25) nie ein Kontakt zwischen dem Mantel (14) und der Messelektrode (25) stattfindet, wobei die Vorrichtung ferner zumindest ein Halteelement (16) mit einem geformten Innenraum (22) umfasst, in dem zumindest die Messelektrode (25) und die Mittel (26), die eine Schwingung anregen können, angeordnet sind, wobei das Halteelement (16) ferner zumindest einen Längskanal aufweist, in den das elektrische Kabel (11) eingeführt und dort fixiert wird.

2. Vorrichtung nach Anspruch 1, **dadurch gekennzeichnet, dass** die Messelektrode (25) zumindest teilweise das elektrische Kabel (11) umschließt.

3. Vorrichtung nach Anspruch 1, **dadurch gekennzeichnet, dass** die Änderung der Ladung über die Zeit einen erkannten Strom (I_{IN}) definiert, der im Wesentlichen proportional zu der Spannung (V_{DC}) in dem elektrischen Kabel (11) ist.

4. Vorrichtung nach Anspruch 1, **dadurch gekennzeichnet, dass** die Mittel, die eine Schwingung anregen können, zumindest ein piezoelektrisches Element (26) umfassen.

5. Vorrichtung nach Anspruch 4, **dadurch gekennzeichnet, dass** das piezoelektrische Element (26) mit Wechselstrom versorgt wird.

6. Vorrichtung nach Anspruch 4, **dadurch gekennzeichnet, dass** sich zwischen dem piezoelektrischen Element (26) und der Messelektrode (25) zumindest ein schwingungsverstärkendes Element (40, 140) befindet.

7. Vorrichtung nach Anspruch 6, **dadurch gekennzeichnet, dass** das schwingungsverstärkende Element in Form eines mit Flügeln versehenen Metallelements (40) vorliegt.

8. Vorrichtung nach Anspruch 6, **dadurch gekennzeichnet, dass** das schwingungsverstärkende Element in Form eines Metallfolienelements (140) vorliegt.

9. Vorrichtung nach Anspruch 1, **dadurch gekennzeichnet, dass** das Halteelement (16) zwei Schalen (18, 19) umfasst, die durch ein Scharnierelement (20) miteinander verbunden und auf der dem Scharnier (20) gegenüberliegenden Seite von einem Einrastelement (21) geklemmt werden.

10. Vorrichtung nach Anspruch 3, **dadurch gekennzeichnet, dass** sie ferner eine Befehls- und Steuereinheit (30) umfasst, die den erkannten Strom (I_{IN}) aufbereiten und verstärken und für die Zuführung zu Signalisierungsmitteln (31) verarbeiten kann.

## Revendications

1. Dispositif pour détecter, sans contact, la tension (V_{DC}) dans un câble électrique (11), notamment dans le domaine automobile, ledit câble électrique (11) comprenant au moins un conducteur (13) enrobé dans une gaine isolante (14), dans lequel le dispositif comprend au moins une électrode de mesure (25) située à proximité dudit conducteur (13) et associée à des moyens (26) aptes à induire une vibration de sorte à produire sur celui-ci une variation de charge corrélée à la tension (V_{DC}) présente dans ledit câble électrique (11), dans lequel ladite électrode de mesure (25) est placée à une certaine distance de ladite gaine isolante (14) et forme, avec ledit conducteur (13), un condensateur, présentant, comme électrodes, l'électrode de mesure (25) et le conducteur (13) lui-même, et comme diélectrique, d'un côté ladite gaine isolante (14) et de l'autre l'espace d'air séparant l'électrode de mesure (25) de la gaine isolante (14), dans lequel ledit espace d'air est égal à au moins deux dixièmes d'un millimètre pour assurer que, pendant le fonctionnement et la vibration de l'électrode de mesure (25), il n'y ait jamais de contact entre ladite gaine (14) et ladite électrode de mesure (25), le dispositif comprenant également au moins un élément de support (16) avec un logement interne façonné (22), dans lequel sont logés au moins ladite électrode de mesure (25) et lesdits moyens (26) aptes à induire une vibration, ledit élément de support (16) comprenant par ailleurs au moins un canal longitudinal dans lequel est inséré et fixé ledit câble électrique (11).

2. Dispositif selon la revendication 1, **caractérisé en ce que** ladite électrode de mesure (25) s'étend au moins en partie autour dudit câble électrique (11).

3. Dispositif selon la revendication 1, **caractérisé en ce que** ladite variation de charge définit, avec le temps, un courant détecté (I_{IN}) sensiblement proportionnel à ladite tension (V_{DC}) dans ledit câble électrique (11).

4. Dispositif selon la revendication 1, **caractérisé en ce que** lesdits moyens aptes à induire une vibration comprennent au moins un élément piézoélectrique (26).

5. Dispositif selon la revendication 4, **caractérisé en ce que** ledit élément piézoélectrique (26) est alimenté en courant alternatif.

6. Dispositif selon la revendication 4, **caractérisé en ce qu'**il y a au moins un élément amplificateur d'oscillation (40, 140) entre ledit élément piézoélectrique (26) et ladite électrode de mesure (25).

7. Dispositif selon la revendication 6, **caractérisé en ce que** ledit élément amplificateur d'oscillation est en forme d'élément en métal à ailettes (40).

8. Dispositif selon la revendication 6, **caractérisé en ce que** ledit élément amplificateur d'oscillation est en forme d'élément en feuille métallique (140).

9. Dispositif selon la revendication 1, **caractérisé en ce que** ledit élément de support (16) comprend deux coques (18, 19) unies par un élément à charnière (20) et serrés sur le côté opposé à la charnière (20) par un élément à encliqueter (21).

10. Dispositif selon la revendication 3, **caractérisé en ce qu'**il comprend par ailleurs une unité de commande et de contrôle (30) apte à conditionner et à amplifier ledit courant détecté (I_{IN}), et à le traiter pour alimenter des moyens de signalisation (31).
